# EUROPEAN PATENT SPECIFICATION

(11) **EP 1 429 884 B1**
(45) Date of publication and mention of the grant of the patent: **21.06.2006**
(21) Application number: 02799642.0
(22) Date of filing: 25.09.2002
(51) Int. Cl.: B23K 1/00, C22C 12/00

(54) **IMPROVED COMPOSITIONS, METHODS AND DEVICES FOR HIGH TEMPERATURE LEAD-FREE SOLDER**
VERBESSERTE ZUSAMMENSETZUNGEN, VERFAHREN UND VORRICHTUNGEN FÜR EIN BLEIFREIES HOCHTEMPERATURLOT
COMPOSITIONS, PROCEDES ET DISPOSITIF AMELIORES DESTINES AU BRASAGE SANS PLOMB HAUTE TEMPERATURE

(30) Priority: 25.09.2001 US 324891 P
(43) Date of publication of application: 23.06.2004
(73) Proprietor: Honeywell International, Inc., Morristown, New Jersey 07962 (US)
(72) Inventor: DEAN, Nancy Honeywell International Inc., Morristown, NJ 07962 (US); LALENA, John Honeywell International Inc., Morristown, NJ 07962 (US); WEISER, Martin Honeywell International Inc., Morristown, NJ 07962 (US)
(74) Representative: Hucker, Charlotte Jane
(86) International application number: PCT/US2002/030608
(87) International publication number: WO 2003/026828

(56) References cited:
- EP-A- 1 103 337
- JP-A- 11 050 296
- JP-A- 11 320 177
- US-A- 4 709 849
- US-A1- 2002 012 608
- US-B1- 6 281 096
- PATENT ABSTRACTS OF JAPAN vol. 1999, no. 05, 31 May 1999 (1999-05-31) & JP 11 050296 A (TOYOTA MOTOR CORP; TOYOTA CENTRAL RES & DEV LAB INC), 23 February 1999 (1999-02-23)
- PATENT ABSTRACTS OF JAPAN vol. 2000, no. 02, 29 February 2000 (2000-02-29) & JP 11 320177 A (MURATA MFG CO LTD), 24 November 1999 (1999-11-24)
- DATABASE CAPLUS [Online] KAMMEL R.; MIRAFZALI H.: 'Vacuum dezincing of bismuth melts', XP002962735 Retrieved from STN Database accession no. 1983:616442 & METALL (ISERNHAGEN, GERMANY vol. 37, no. 9, 1983, pages 891 - 897
- DATABASE CAPLUS [Online] OJHA S.N.; MANDAL R.K.: 'Faceting behavior of primary phase in Ag-Bi alloys', XP002962736 Retrieved from STN Database accession no. 1996:182838 & JOURNAL OF MATERIALS SCIENCE LETTERS vol. 15, no. 4, 1996, pages 326 - 328

## Description

### FIELD OF THE INVENTION

The field of the invention is lead-free solders and solder materials.

### BACKGROUND

Numerous known die attach methods utilize a high-lead solder or solder material to attach the semiconductor die within an integrated circuit to a leadframe for mechanical connection and to provide thermal and electrical conductivitybetween the die and leadframe. Although most high-lead solders are relatively inexpensive and exhibit various desirable physico-chemical properties, the use of lead in die attach and other solders has come under increased scrutiny from an environmental and occupational health perspective. Consequently, various approaches have been undertaken to replace lead-containing solders with lead-free die attach compositions.

For example, in one approach, polymeric adhesives (*e.g.,* epoxy resins or cyanate ester resins) are utilized to attach a die to a substrate as described in U.S. Pat. Nos. 5,150,195; 5,195,299; 5,250,600; 5,399,907 and 5,386,000. Polymeric adhesives typically cure within a relatively short time at temperatures generally below 200°C, and may even retain structural flexibility after curing to allow die attach of integrated circuits onto flexible substrates as shown in U.S. Pat. No. 5,612,403. However, many polymeric adhesives tend to produce resin bleed, potentially leading to undesirable reduction of electrical contact of the die with the substrate, or even partial or total detachment of the die.

To circumvent at least some of the problems with resin bleed, silicone-containing die attach adhesives may be utilized as described in U.S. Pat. No. 5,982,041 to Mitani et al. While such adhesives tend to improve the bonding of the wire, as well as that between the resin sealant and the semiconductor chip, substrate, package, and/or lead frame, the curing process for at least some of such adhesives requires a source of high-energy radiation, which may add significant cost to the die attach process.

Alternatively, a glass paste comprising a high-lead borosilicate glass may be utilized as described in U.S. Pat. No. 4,459,166 to Dietz et al., thereby generally avoiding a high-energy curing step. However, many glass pastes comprising a higti-lead borosilcate glass require temperature of 425°C and higher to permanenly bond the die to the substrate. Moreover, glass pastes frequently tend to crystallize during heating and cooling, thereby reducing the adhesive qualities of the bonding layer.

In yet another approach, various high melting solders are utilized to attach a die a substrate or leadframe. Soldering a die to a substrate has various advantages, including relatively simple processing solvent-free application, and in some instances relatively low cost. There are various high melting solders known in the art. However, an or almost all of them have one or more disadvantages. For example, most gold eutectic alloys (e.g., Au-20% Sn, Au-3% Si, Au-12% Ge, and Au-25% Sb) are relatively costly and frequently suffer frm less-than-ideal mechanical properties. Alternatively, Alloy J (Ag-10%Sb-65% Sn, see e.g. U.S. Pat. No. 4,170,472 to Olsen et al.) may be used in various high melting solder applications. However, Alloy J has a solidus of 228°C and also suffers from relatively poor mechanical performance.

Although various methods and compositions for solders and die attach compositions are known in the art, all or almost all of them suffer from one or more Thus, there is still a need to provide improved compositions and methods for solders, and particularly for lead-free solders.

### SUMMARY OF THE INVENTION

According to a first aspect of the present invention, an alloy composition is defined in claim 1. The composition finds, use in electronic devices, and as a solder. According to a second aspect of the invention, a method of making a solder composition is defined in claim 16.

In one aspect of the inventive subjectmatter, the silver in the alloy is present in an amount of 2 wt% to 7 wt% and the bismuth in an amount of 98 wt% to 93 wt%, or the silver in the allay is present in an amount of 7 wt% to 18 wt% and the bismuth in an amount of 93 wt% to 82 wt%, or the silver in the alloy is present in an amount of 5 wt% to 9 wt% and the bismuth in an amount of 95 wt% to 91 wt%. Contemplated compositions may further comprise a chemical element selected from AI, Ba, Ca, Ce, Cs, Hf, Li, Mg, Nd, Sc, Sr, P, Ti, Y and Zr, and especially The concentration of contemplated elements is in a range of between 10 ppm and 1000 ppm.

In another aspect of the inventive subject matter, contemplated solders have a thermal conductivity of at least 9 W/m K, and exhibit a wetting force to wet various substrates, includes those comprising Cu, Ag, Ni, and An, of approximately 02 micro-N/mm on a wetting balance after 1 second. Contemplated compositions may be formed into various shapes, including wires, ribbons preforms, spheres, or ingots.

In a yet another aspect, contemplated compositions comprise Bi (85 wt% to 98 wt%) and Ag (2 wt%to 15 wt%), and at least ane of zinc, nickel, germanium or a combination thereof in a range of 10 ppm to 1000 ppm. Such compositions may further include phosphorus in a range of 10 ppm to 500 ppm. An.example of contemplated compositions include alloys in which Bi is present at about 89 wt%, Ag at about 11 wt%, and at least one of zinc, nickel, germanium or a combination thereof at about 500 ppm (with optional addition of phosphorus up to 250 ppm), wherein such compositions have improved wettability on at least Cu and Ni over similar compositions without zinc, nickel, germanium, phosphorus and/or a combination thereof.

In a further aspect of the inventive subject matter, an electronic device comprises a semiconductor die that is coupled to a surface via contemplated compositions, wherein particularly contemplated semiconductor dies include silicon, germanium, and gallium arsenide dies. It is further contemplated that at least one of a portion of the die at a portion of the surface of such devices may be metallized with silver. In particularly preferred aspects, the surface comprises a silver-metallized leadframe. In further aspects, contemplated solders are utilized in an area array electronic package in form of a plurality of bumps on a semiconductor die to serve as electrical interconnects between the die and either a package substrate (generally known as flip chip) or a printed wiring board (generally known as chip on board). Alternatively, contemplated solders may be utilized in the form of a plurality of solder balls to connect a package to a substrate (generally known as ball grid array with many variations on the theme) or to connect the die to either a substrate or printed wiring board.

In a still further aspect of the inventive subject matter, a method of manufacturing a solder composition has one step in which bismuth and silver are provided in an amount of 98 wt% to 82 wt% and 2 wt% to 18 wt%, respectively, wherein the at least one of zinc, nickel, germanium or a combination thereof is present in an amount of up to 1000 ppm, and any optional chemical elements (as defined above) are present in an amount of 10 ppm to 1000 ppm, in a further step, the silver, bismnth, and the at least one of zinc, nickel, germanium or a combination thereof, and any optional chemical elements, are melted at a temperature of at least 960°C to form an alloy having a solidus of no lower than 262.5°C and a liquidus of no higher than 400°C.

Various objects, features, aspects and advantages of the present invention will become more apparent from the following detailed description of preferred embodiments of the invention along with the accompanying drawing.

### BRIEF DESCRIPTION OF THE DRAWINGS

Figure 1 is a Ag-Bi phase diagram.
Figure 2 is an electron micrograph of an exemplary Ag-Bi alloy.
Figure 3 is a Ge-Ni phase diagram.
Figure 4 is a graph depicting thermal conductivity of Ag-Bi with varying Ag content.
Figures 5A and 5B are graphs depicting wetting forces of contemplated alloys on various substrates..
Figure 6 is a table showing calculated contact angles of various alloys.
Figure 7 is a photograph of exemplary wetting behavior of contemplated alloys on Ni-plated leadframes with various concentrations of germanium.
Figure 8 is a schematic vertical cross section of a contemplated electronic device.
Figures 9A and 9B are photographs/SAM-microscopy photographs of dies attached to leadframes using exemplary alloys.
Figure 10A is a Ni-Bi phase diagram.
Figure 10B is an electron micrograph of an exemplary alloy with specific regard to Ni and Bi.
Figures 11A and 11B are electron micrographs of substrates showing completed Ag scavenging.
Figure 12 is a table summarizing various physical properties of various alloys.

### DETAILED DESCRIPTION

It has been discovered that, among other desirable properties, contemplated compositions may advantageously be utilized as near drop-in replacements for high-lead-containing solders in various die attach applications. In particular, contemplated compositions are lead-free alloys having a solidus ofno lower than 260°C (and preferably no lower than 262.5°C) and a liquidus no higher than 400°C. Various aspects of the contemplated methods and compositions are disclosed in copending PCT application PCT/US01/17491 incorporated herein in its entirety.

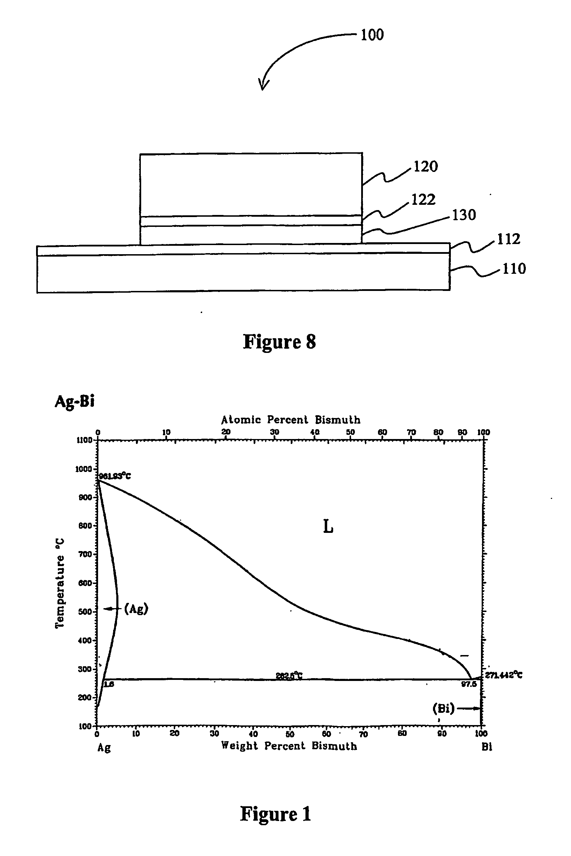

Figure 1 shows an Ag-Bi phase diagram. Compositions contemplated herein can be prepared by a) providing a charge of appropriately weighed quantities (supra) of the pure metals; b) heating the metals under vacuum or an inert atmosphere (*e.g.*, nitrogen or helium) to between about 960°C-1000°C in a refractory or heat resistant vessel (*e.g*., a graphite crucible) until a liquid solution forms; and c) stirring the metals at that temperature for an amount of time sufficient to ensure complete mixing and melting of both metals. Nickel, zinc, germanium or combinations thereof may be added to the charge or molten material at dopant quantities of up to 1000 ppm, and more preferably ofup to 500 ppm.

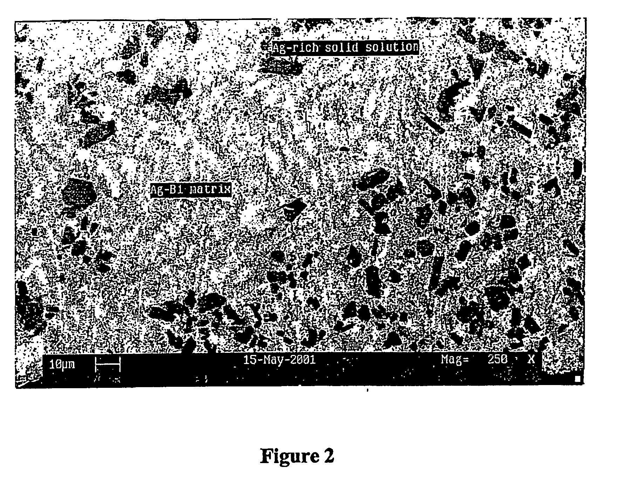

The molten mixture, or melt, is then quickly poured into a mold, allowed to solidify by cooling to ambient temperature, and fabricated into wire by conventional extrusion techniques, which includes heating the billet to approximately 190°C, or into ribbon by a process in which a rectangular slab is first annealed at temperatures between 225-250°C and then hot-rolled at the same temperature. Alternatively, a ribbon may be extruded that can subsequently be rolled to thinner dimensions. The melting step may also be carried out under air so long as the slag that forms is removed before pouring the mixture into the mold. Figure 2 shows an electron micrograph, in which the Ag-Bi alloy appears to form a hypoeutectic alloy wherein the primary constituent (silver) is surrounded by fine eutectic structure. As can be seen from the electron micrograph, there is only negligible mutual solubility in the material, thus resulting in a more ductile material than bismuth metal.

In other embodiments, especially where higher liquidus temperatures are desired, contemplated compositions may include Ag in the alloy in an amount of 7 wt% to 18 wt% and Bi in an amount of 93 wt% to 82 wt%. On the other hand, where relatively lower liquidus temperatures are desired, contemplated compositions may include Ag in the alloy in an amount of 2 wt% to 7 wt% and Bi in an amount of 98 wt% to 93 wt%. However, it is generally contemplated that most-die attach applications may employ a composition in which Ag is present in the alloy in an amount of 5 wt% to 12 wt% and Bi in an amount of 95 wt% to 89 wt%. For these embodiments, an exemplary alloy may have the composition of Bi at 89 wt% and Ag at 11 wt%.

It should be particularly appreciated that contemplated compositions may be utilized as lead-free solders that are also essentially devoid ofSn, which is acommon and predominant component in known lead-free solder. Moreover, while it is generally contemplated that particularly suitable compositions are binary alloys, it should also be appreciated that alternative compositions may include ternary, quaternary, and higher alloys.

As mentioned aboves the compositions may include one or more chemical elements selected from Al, Ba, Ca, Ce, Cs, Hf, Li, Mg, Nd, P, Sc, Sr, Ti, Y and Zx, and it is further contemplated that such chemical elements may be present in the alloy at a concentration of between 10 ppm and 1000 ppm. While not wishing to be bound to a particular theory or mechanism, it is contemplated that as these elements have a higher oxygen affinity than the alloy this reduces the formation of metal oxides that are known to mcrease the surface tension of a melting or molten solder. Therefore, it is contemplated that a decrease in the amount of metal oxides during soldering will generally reduce the surface tension of the molten solder, and thereby significantly mcreases the wetting ability of the solder.

Moreover, it is particularly contemplated that phosphorus (P) may be added to improve wetting alone or in combination with other metals (*e.g.*, germanium (Ge)). While not wishing to be bound to a particular theory or hypothesis it is contemplated that phosphorus may act as a flux, and that addition or synergistic effects of phosphorus with other metals may further improve wettability to at least some substrates (*e.g.*, to a substrate comprising Ag, infra). In this regard, a chemical element may be added that forms an intermetallic complex or compound with nickel, copper, gold, silver or a combination thereof.

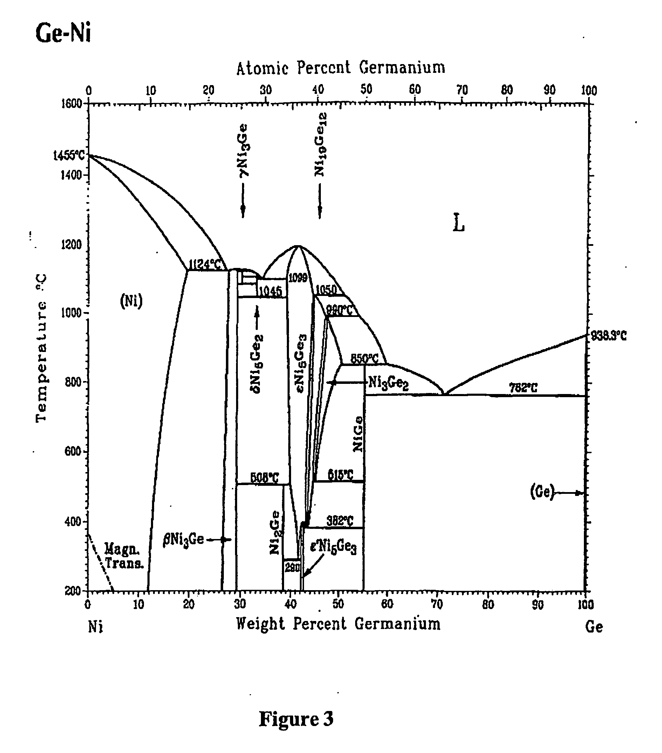

The at least one of zinc, nickel, germanium or a combination thereof is present in preferred alloys in a range of between 10 ppm and 1000 ppm, more typically in a range of between 200 ppm and 700 ppm, and most typically at a concentration of about 500 ppm. Addition of the at least one of zinc, nickel, germanium or a combination thereof was observed to improve wettability to substrates plated with various metals, particularly including copper and nickel, or a bare metal that has not been plated, such as a leadframe, where the at least one of zinc, nickel, germanium or a combination thereof were added in amounts of between 10 ppm to 100 ppm. While not wishing to be bound to a particular theory, it is contemplated that the at least one of zinc, nickel, germanium or a combination thereof may advantageously form intermetallic complexes with Ni, or reduce an oxide film by allowing preferential oxidation, and thereby contribute to the increase in the wetting force. A Ni-Ge phase diagram is depicted in Figure 3, indicating the potential for various Ni-Ge intermetallic complexes and partial Ge-Ni solid solubility. Furthermore, it is contemplated that a preferential surface oxidation of germanium may occur. Based on this discussion, a contemplated composition includes an alloy comprising (or consisting of) Bi at about 89 wt%, Ag at about 11 wt%, and the at least one of zinc, nickel, germanium or a combination thereof in a range between 10 ppm and 1000 ppm, more preferably about 500 ppm. Such contemplated alloys may further include phosphorus in an amount of up to 1000 ppm, and more typically about 200 ppm. Furthermore, it should be appreciated that addition ofGe to contemplated compositions within a range of 10 ppm to 1000 ppm will not significantly lower the solidus of such compositions. While preferred alloys comprise Ge in an amount of between 10 ppm to 1000 ppm, it should also be recognized that Ge may also be present as dopant in concentrations of between 10 ppm and 1 ppm (and even less), or as an alloy component in concentrations between 1000 ppn and 5 wt%, and even higher (e.g., between 5 wt% and 7 wt%, or between wt% and 10 wt% and even higher).

Consequently, and depending on the concentration/amount of the third element (the at least one of zinc, nickel, germanium or a combination thereof it should be recognized that such alloys will have a solidus of no lower than 230°C, more preferably no lower than 248°C, and most preferably no lower than 258°C and a liquidus of no higher than 400°C. Especially contemplated uses of such alloys includes die attach applications (*e.g.*, attachment of a semiconductor die to a substrate). Consequently, it is contemplated that an electronic device will comprise a semiconductor die coupled to a surface via a material comprising the composition that includes contemplated ternary (or higher) alloys. With respect to the production of contemplated ternary alloys, the same considerations as outlined above apply. In general, it is contemplated that the third element (or elements) is/are added in appropriate amounts to the binary alloy or binary alloy components.

It should further be appreciated that addition of chemical elements or metals to improve one or more physico-chemical or thermo-mechanical properties can be done in any order so long as all components in the alloy are substantially *(i.e.,* at least 95% of each component) molten, and it is contemplated that the order of addition is not limiting to the inventive subject matter. Similarly, it should be appreciated that while it is contemplated that silver and bismuth are combined prior to the melting step, it is also contemplated that the silver and bismuth may be melted separately, and that the molten silver and molten bismuth are subsequently combined. A further prolonged heating step to a temperature above the melting point of silver may be added to ensure substantially complete melting and mixing of the components. It should be particularly appreciated that when one or more additional elements are included, the solidus of contemplated alloys may decrease. Thus, contemplated alloys with such additional alloys may have a solidus in the range of 260-255°C, in the range of 255-250°C, in the range of 250-245°C, in the range of 245-235°C, and even lower.

Where additional elements are added, and especially where the at least one of zinc, nickel, germanium or a combination thereof is/are added, it is contemplated that the at least one of zinc, nickel, germanium or a combination thereof may be added in any suitable form (e.g., powder, shot, or pieces) in an amount sufficient to provide the desired concentration of the at least one of zinc, nickel, germanium or a combination thereof, and the addition of the third element/elements may be prior to, during, or after melting the Bi and Ag.

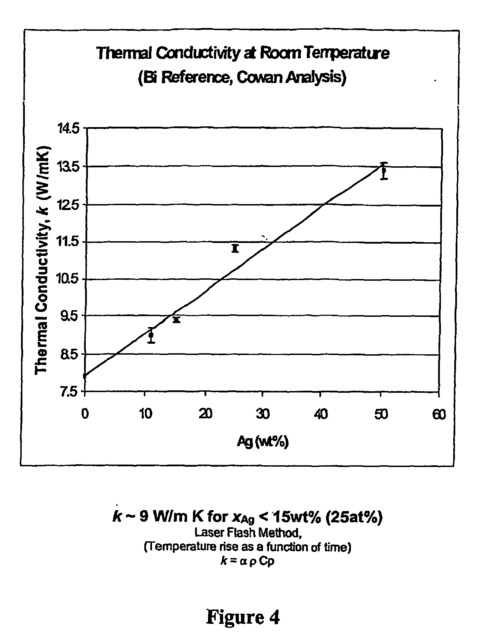

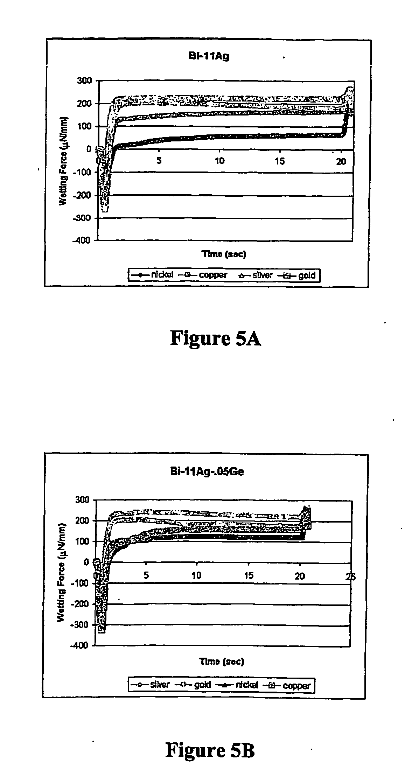

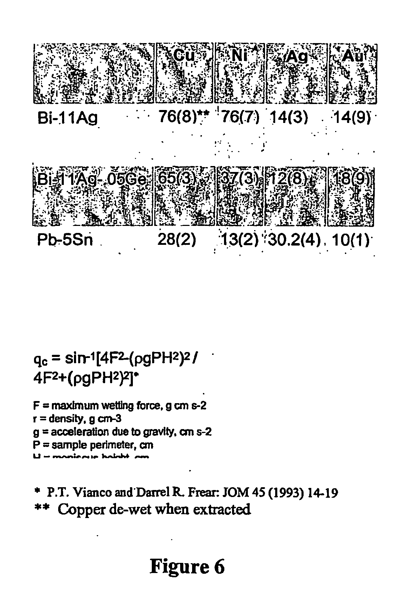

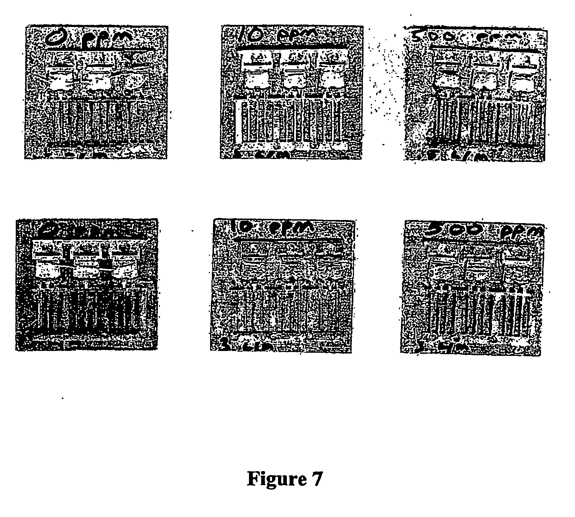

With respect to thermal conductivity of contemplated alloys, it is contemplated that compositions disclosed herein have a conductivity of no less than 5 W/m K, more preferably of no less than9 W/m K, and most preferably of no less than 15 W/m K. Thermal conductivity analysis for some of the contemplated alloys using a laser flash method indicated thermal conductivity of at least 9 W/m K is depicted in Figure 4. It is further contemplated that suitable compositions. (*e.g*., Bi-11Ag with about 500 ppm Ge) include a solder having a wetting force to wet Ag, Ni, Au, or Cu ofbetween 125 micro-N/mm to 235 micro-N/mm on a wetting balance after about 1 second (see e.g., exemplary graphs as shown in **Figures 5A and 5B** depicting test results of contemplated alloys on various coated substrates). The improved wettability is also reflected in the change in calculated contact angle (air, with aqueous flux) which is depicted in **Figure 6**. Moreover, contemplated alloys were applied to Ni-plated leadframes under N₂/H₂ atmosphere, and the results are depicted in Figure 7 for Bi-11Ag-xGe (x = 0, 10, and 500 ppm), wherein the upper series was at a moderately low pO₂ content and the lower series was at a lower pO₂ content

It is still further contemplated that a particular shape of contemplated compositions is not critical to the inventive subject matter. However, it is preferred that contemplated compositions are formed into a wire shape, ribbon shape, or a spherical shape (solder bump).

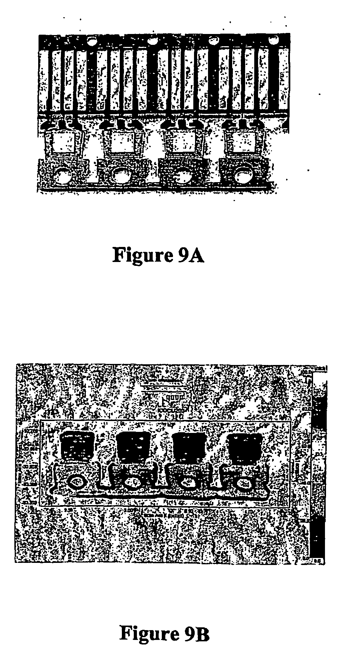

Among various other uses, contemplated compounds (*e.g.*, in wire form) may be used to bond a first material to a second material. For example, contemplated compositions (and materials comprising contemplated compositions) may be utilized in an electronic device to bond a semi-conductor die (*e.g.*, silicon, germanium, or gallium arsenide die) to a leadframe as depicted in **Figure 8**. Here, the electronic device 100 comprises a leadframe 110 that is metallized with a silver layer 112. A second silver layer 122 is deposited on the semiconductor die 120 (e.g., by backside silver metallization). The die and the leadframe are coupled to each other via their respective silver layers by contemplated composition 130 (here, eg., a solder comprising an alloy that includes Ag in an amount of 2 wt% to 18 wt% and Bi in an amount of 98wt% to 82 wt%, wherein the alloy has a solidus of no lower than 262.5°C and a liquidus of no higher than 400°C). In an optimum die attach process, contemplated compositions are heated to about 40°C above the liquidus of the particular alloy for 15 seconds and preferably no higher than 430°C for no more than 30 seconds. The soldering can be carried out under a reducing atmosphere (e.g., hydrogen or forming gas). A die attachment experiment was performed using a solder wire comprising contemplated alloys with a Ni-coated leadframe and a semiconductor die as shown in figures 9A (photograph) and 9B (SAM [Scanning acoustic microscopy] analysis).

In further alternative aspects, it is contemplated that the compounds disclosed herein maybe utilized in numerous soldering processes other than die attach applications. In fact, contemplated compositions may be particularly useful in all, or almost all, step solder applications in which a subsequent soldering step is performed at a temperature below the melting temperature of contemplated compositions. Furthermore, contemplated compositions may also be utilized as a solder in applications where high-lead solders need to be replaced with lead-free solders, and solidus temperatures of greater than 260°C are desirable. Particularly preferred alternative uses include use of contemplated solders in joining components of a heat exchanger as a non-melting standoff sphere or electrical/thermal interconnection.

### EXAMPLES

Due to the differences in the coefficient of thermal expansion of various materials, solder joints will frequently experience shear loading. Therefore, it is especially desirable that alloys coupling such materials have a low shear modulus and, hence, good thermomechanical fatigue resistance. For example, in die attach applications, low shear modulus and good thermomechanical fatigue help prevent cracking of a die, especially where relatively large dies are coupled to a solid support.

Based on the known elastic moduli of the pure metals, the fact that Ag and Bi exhibit partial solid miscibility, and the fact that the Ag-Bi system contains no intermetallic or intermediate phases, it has been calculated that the room temperature shear modulus of contemplated Ag-Bi alloys will be in the range of about 13-16 GPa (assuming room temperature shear modulus to be an additive property- *i.e.,* following the rule-of-mixtures). Room temperature shear moduli in the range of about 13-16 GPa of contemplated alloys are especially favorable in comparison to 25 GPa for both Au-25% Sb and Au-20% Sn alloys (calculated by the same method and making the same assumption), and 21 GPa for Alloy J (Ag-10% Sb-65% Sn), with 22.3 GPa being a measured value for Alloy J. Further experiments confirmed previous calculations and established the following shear moduli for the following alloys: Bi-11Ag = 13.28 Gpa; Bi-9Ag =13.24 Gpa; Au-20Sn = 21.26 Gpa; Sn-25sb-10Ag (Alloy J) = 21.72 Gpa; and Pb-5Sn = 9.34 GPa. Still further experiments (data not shown) indicate that the shear strength of Bi-11Ag and Pb-5Sn are comparable.

Additional mechanical properties are depicted below in Table 1 summarizing data on liquidus, UTS, and ductility (in % elongation) for solder wire:

**TABLE 1**

| **Alloy** | **Liquidus** | **UTS** | **Ductility** |
|---|---|---|---|
| Pb-5Sn | 315 | 25.4 | 38.0 |
| Pb-2.5Ag-2Sn | 296 | 31.5 | 22.0 |
| Sn-8.5Sb | 246 | 52.4 | 55.0 |
| Bi-11Ag | 360 | 59.0 | 34.6 |
| Bi-11Ag-0.05Ge | 360 | 69.7 | 19.1 |
| Sn-25Ag-10Sb | 395 | 109.4 | 10.4 |

Various experiments were also performed to identify suitable concentrations of a third metal (in this case: Ge) in contemplated alloys to improve wettability of such alloys to substrates that are plated with various metals, including Ag, Ni, Au, and Cu as indicated in Table 2 (all numbers in µN/mm; phosphorus was added at 100 ppm for Cu-plated, and 1000 ppm for all other metal-plated sets):

**TABLE 2**

| | **5000ppm Ge** | **2000ppm Ge** | **1000ppm Ge** | **500ppm Ge** | **500ppm Ge + 200ppm P** | **Bi-9Ag** | **Bi-9Ag + p** |
|---|---|---|---|---|---|---|---|
| Wrought-Cu | 200 | 200 | 200 | 200 | 200 | 100 | 150 |
| Ni-plated | 125 | 100 | 125 | 125 | 150 | 50 | 110 |
| Ag-plated | 225 | 235 | N/A | 225 | 235 | 215 | 225 |
| Au-plated | 225 | 235 | N/A | 235 | 245 | 230 | 250 |

Similarly, data were obtained for Bi-11Ag with and without addition of 500ppm Ge, and the results are depicted in Table 3:

**TABLE 3**

| | **500ppm Ge** | **Bi-11Ag** |
|---|---|---|
| Wrought-Cu | 185 | 165 |
| Ni-plated | 125 | 65 |
| Ag-plated | 225 | 215 |
| Au-plated | 235 | 230 |

Thus, addition ofGe to Bi-11Ag increases the maximum wetting force (µN/mm) as indicated in Table 4:

**TABLE4**

| | **Bi-11Ag** | **Plus P** | **Plus Ge** |
|---|---|---|---|
| Wrought-Cu | ~90 | ~125 | ~200 |
| Ni-plated | -50 | ~110 | ~125 |

While addition of germanium to increase the wetting force is contemplated, it should also be appreciated that numerous alternative elements (especially nickel, zinc and or combinations thereof with or without germanium) are also considered suitable for use herein, and particularly contemplated elements include those that can form intermetallic complexes with the metal to which the alloy is bonded.

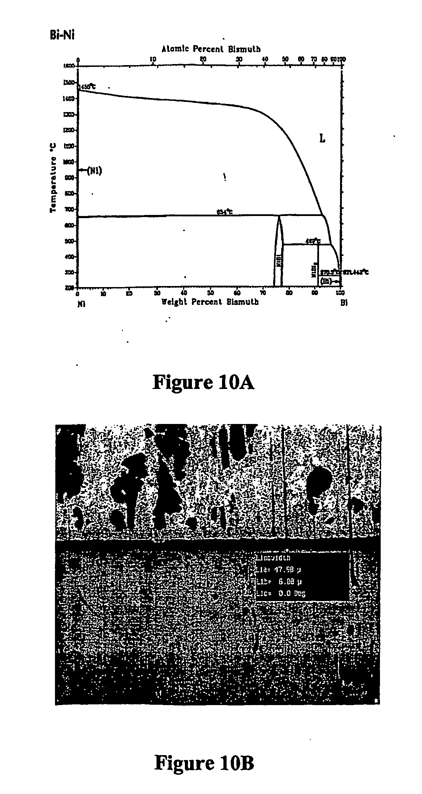

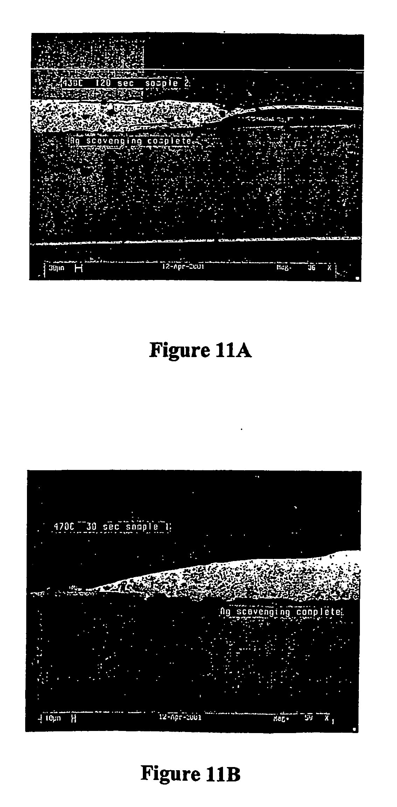

Test assemblies constructed of a silicon die bonded to a leadframe with Ag-89% Bi alloy have shown no visible signs of failure after 1500 thermal aging cycles, which is in further support of the calculated and observed low shear modulus of contemplated Ag-Bi alloys. In a further set of experiments, contemplated alloys were bonded to aNi-plated substrate. As could be anticipated from the Ni-Bi phase diagram depicted in **Figure 10A,** intermetallic complexes may be formed at the Ni-solder alloy interface as shown in **Figure 10B.** Similarly, contemplated alloys were bonded on a Ag-plated substrate, and silver scavenging could be observed under conditions as indicated in **Figures 11A** and **11B.**

Bond strength measurements were performed with various samples, and the results and average of the samples are indicated in Table 5 below (MIL-STD-883E Method 2019.5 calls for a minimum force of 2.5 kg or a multiple thereof):

**TABLE5**

| **Unit Number** | **Die Size (cm**^{**2**}**)** | **Shear Strength (kg)** | **Remarks** |
|---|---|---|---|
| 1 | 0.2025 | 25.0 | Cohesive failure |
| 2 | 0.2025 | 53.7 | Die chipped off |
| 3 | 0.2025 | 29.0 | Cohesive failure |
| 4 | 0.2025 | 24.6 | Die still intact |
| 5 | 0.2025 | 32.6 | Die still intact |
| 6 | 0.2025 | 22.0 | |
| 7 | 0.2025 | 32.6 | |
| 8 | 0.2025 | 69.5 | |
| 9 | 0.2025 | 28.2 | |
| 10 | 0.2025 | 20.7 | |
| 11 | 0.2025 | 14.1 | |
| 12 | 0.2025 | 18.9 | |
| Average | 0.2025 | 30.9 | |

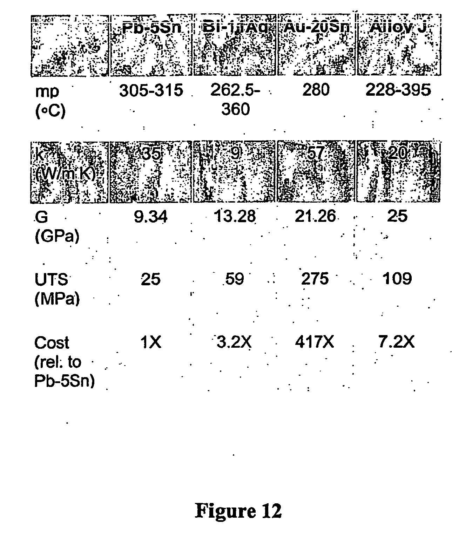

A summary of some of the physical properties and cost of contemplated alloys (and comparative alloys) is depicted in **Figure 12,** which clearly demonstrates the overall advantage of contemplated alloys.

In the test assemblies and various other die attach applications the solder is generally made as a thin sheet that is placed between the die and the substrate to which it is to be soldered. Subsequent heating will melt the solder and form the joint. Alternatively the substrate can be heated followed by placing the solder on the heated substrate in thin sheet, wire, melted solder, or other form to create a droplet of solder where the semiconductor die is placed to form the joint.

For area array packaging contemplated solders can be placed as a sphere, small preform, paste made from solder powder, or other forms to create the plurality of solder joints generally used for this application. Alternatively, contemplated solders may be used in processes comprising plating from a plating bath, evaporation from solid or liquid form, printing from a nozzle like an ink jet printer, or sputtering to create an array of solder bumps used to create the joints.

In a contemplated method, spheres are placed on pads on a package using either a flux or a solder paste (solder powder in a liquid vehicle) to hold the spheres in place until they are heated to bond to the package. The temperature may either be such that the solder spheres melt or the temperature may be below the melting point of the solder when a solder paste of a lower melting composition is used. The package with the attached solder balls is then aligned with an area array on the substrate using either a flux or solder paste and heated to form the joint

A preferred method for attaching a semiconductor die to a package or printed wiring board includes creating solder bumps by printing a solder paste through a mask, evaporating the solder through a mask, or plating the solder on to an array of conductive pads. The bumps or columns created by such techniques can have either a homogeneous composition so that the entire bump or column melts when heated to form the joint or can be inhomogeneous in the direction perpendicular to the semiconductor die surface so that only a portion of the bump or column melts.

Thus, specific embodiments and applications of lead-free solders have been disclosed. It should be apparent, however, to those skilled in the art that many more modifications besides those already described are possible without departing from the inventive concepts herein. The inventive subject matter, therefore, is not to be restricted except in the spirit of the appended claims. Moreover, in interpreting both the specification and the claims, all terms should be interpreted in the broadest possible manner consistent with the context. In particular, the terms "comprises" and "comprising" should be interpreted as referring to elements, components, or steps in a non-exclusive manner, indicating that the referenced elements, components, or steps maybe present, or utilized, or combined with other elements, components, or steps that are not expressly referenced.

## Claims

1. A composition comprising:
an alloy that comprises Ag in an amount of 2 wt% to 18 wt%, at least one of zinc, nickel, germanium or a combination thereof present in an amount of up to 1000 ppm, and optionally a 10 ppm to 1000 ppm a chemical element selected from Al, Ba, Ca, Ce, Cs, Hf, Li, Mg, Nd, P, Sc, Sr, Ti, Y and Zr, the balance being Bi, wherein the alloy has a solidus of no lower than 262.5°C and a liquidus of no higher than 400°C.

2. The composition of claim 1, wherein the Ag in the alloy is present in an amount of 7 wt% to 18 wt% and Bi in an amount of 93 wt% to 82 wt%.

3. The composition of claim 1, wherein the Ag in the alloy is present in an amount of about 11 wt% and Bi in an amount of about 89 wt%.

4. The composition of claim, wherein the at least one of zinc, nickel germanium or a combination thereof is present in an amount of 10 ppm to 1000 ppm.

5. The composition of claim 1, wherein the at least one of zinc, nickel, germanium or a combination thereof is present in an amount of about 500 ppm.

6. The composition of claim 1, wherein the solder has a thermal conductivity of no less than 9 W/mK.

7. The composition of claim 1, wherein the solder has a wetting force to wet Ag, Ni, Au, or Cu of approximately 0.2 micro-N/mm on a wetting balance after 1 second.

8. The composition of claim 1, wherein the chemical element is phosphorus.

9. The composition of claim 1, wherein the alloy is formed into at least one of a wire, a ribbon, a preform, an anode, a sphere, a paste, and an evaporation slug.

10. The composition of claim 1, which comprises germanium.

11. The composition of claim 10, which comprises germanium in a concentration between about 10 ppm and about 1000 ppm.

12. An electronic device comprising a semiconductor die coupled to a surface via a material comprising the composition according to claim 1.

13. The electronic device of claim 12, wherein at least a portion of the semiconductor die is metallized with Ag.

14. The electronic device of claim 12, wherein at least a portion of the surface is metallized with Ag, Cu, Ni, or Au.

15. The electronic device of claim 12, wherein the surface comprises a silver-metallized or a nickel-metallized leadframe.

16. A method of manufacturing a solder composition, comprising: providing the components of the alloy defined in claim 1, in the amounts defined in claim 1, and melting the components to a temperature of at least 960°C to form a solder composition having a solidus of no lower than 262.5°C and a liquidus of no higher than 400°C.

17. The method of claim 16, wherein the Ag is present in an amount of 7 wt% to 18 wt% and Bi in an amount of 98 wt% to 82 wt%.

18. The method of claim 16, wherein the at least one of zinc, nickel, germanium or a combination thereof is present in an amount of about 500 ppm.

19. Use of a composition as defined in any of claims 1 to 11, as a solder.

## Patentansprüche

1. Zusammensetzung, umfassend:
eine Legierung, die Ag in einer Menge von 2 Gew.-% bis 18 Gew.-%, mindestens eines von Zink, Nickel, Germanium oder einer Kombination davon, das in einer Menge von bis zu 1000 ppm vorhanden ist, und wahlweise 100 ppm bis 1000 ppm eines chemischen Elements, ausgewählt aus Al, Ba, Ca, Ce, Cs, Hf, Li, Ma, Nd, P, Sc, Sr, Ti, Y und Zr, umfasst, wobei der Rest aus Bi besteht, wobei die Legierung einen Soliduspunkt von nicht niedriger als 262,5 °C und einen Liquiduspunkt von nicht höher als 400 °C aufweist.

2. Zusammensetzung nach Anspruch 1, wobei das Ag in der Legierung in einer Menge von 7 Gew.-% bis 18 Gew.-% und Bi in einer Menge von 93 Gew.-% bis 82 Gew.-% vorhanden ist.

3. Zusammensetzung nach Anspruch 1, wobei das Ag in der Legierung in einer Menge von 11 Gew.-% und Bi in einer Menge von 89 Gew.-% vorhanden ist.

4. Zusammensetzung nach Anspruch 1, wobei das mindestens eine von Zink, Nickel, Germanium oder einer Kombination davon in einer Menge von 10 bis 1000 ppm vorhanden ist.

5. Zusammensetzung nach Anspruch 1, wobei das mindestens eine von Zink, Nickel, Germanium oder einer Kombination davon in einer Menge von etwa 500 ppm vorhanden ist.

6. Zusammensetzung nach Anspruch 1, wobei das Lot eine Wärmeleitfähigkeit von nicht weniger als 9 W/mK aufweist.

7. Zusammensetzung nach Anspruch 1, wobei das Lot nach 1 Sekunde auf einer Benetzungswaage eine Netzkraft zum Benetzen von Ag, Ni, Au oder Cu von etwa 0,2 µN/mm aufweist.

8. Zusammensetzung nach Anspruch 1, wobei das chemische Element Phosphor ist.

9. Zusammensetzung nach Anspruch 1, wobei die Legierung zu mindestens einem aus einem Draht, einem Band, einer Vorform, einer Anode, einer Kugel, einer Paste und einem Verdampfungskern geformt ist.

10. Zusammensetzung nach Anspruch 1, die Germanium umfasst.

11. Zusammensetzung nach Anspruch 10, die Germanium in einer Konzentration zwischen etwa 10 ppm und etwa 1000 ppm umfasst.

12. Elektronische Vorrichtung, umfassend einen Halbleiter-Die, der über ein Material, das die Zusammensetzung nach Anspruch 1 umfasst, mit einer Fläche verbunden ist.

13. Elektronische Vorrichtung nach Anspruch 12, wobei mindestens ein Teil des Halbleiter-Dies mit Ag metallisiert ist.

14. Elektronische Vorrichtung nach Anspruch 12, wobei mindestens ein Teil der Oberfläche mit Ag, Cu, Ni oder Au metallisiert ist.

15. Elektronische Vorrichtung nach Anspruch 12, wobei die Oberfläche einen mit Silber metallisierten oder mit Nickel metallisierten Bleirahmen umfasst.

16. Verfahren zur Herstellung einer Lotzusammensetzung, umfassend:
Bereitstellen der Bestandteile der in Anspruch 1 definierten Legierung in den Mengen, die in Anspruch 1 definiert sind, und Schmelzen der Bestandteile auf eine Temperatur von mindestens 960°C, um eine Lötzusammensetzung mit einem Soliduspunkt von nicht niedriger als 262,5 °C und einem Liquiduspunkt von nicht höher als 400 °C zu bilden.

17. Verfahren nach Anspruch 16, wobei das Ag in einer Menge von 7 Gew.-% bis 18 Gew.-% und Bi in einer Menge von 98 Gew.-% bis 82 Gew.-% vorhanden ist.

18. Verfahren nach Anspruch 16, wobei das mindestens eine von Zink, Nickel, Germanium oder einer Kombination davon in einer Menge von etwa 500 ppm vorhanden ist.

19. Verwendung einer Zusammensetzung wie in einem der Ansprüche 1 bis 11 definiert als Lot.

## Revendications

1. Composition comprenant :
un alliage qui comprend Ag à raison de 2 % en poids à 18 % en poids, au moins un des éléments zinc, nickel, germanium, ou une combinaison de ceux-ci, présents à raison de jusqu'à 1000 ppm, et éventuellement 10 ppm à 1 000 ppm d'un élément chimique choisi parmi Al, Ba, Ca, Ce, Cs, Hf, Li, Mo, Nd, P, Sc, Sr, Ti, Y et Zr, le complément étant Bi, dans laquelle l'alliage possède un solidus non inférieur à 262,5°C et un liquidus non supérieur à 400°C.

2. Composition selon la revendication 1, dans laquelle l'Ag dans l'alliage est présent à raison de 7 % en poids à 18 % en poids et Bi à raison de 93 % en poids à 82 % en poids.

3. Composition selon la revendication 1, dans laquelle l'Ag dans l'alliage est présent à raison d'environ 11 % en poids et Bi à raison d'environ 89 % en poids.

4. Composition selon la revendication 1, dans laquelle le ou les éléments zinc, nickel, germanium, ou une combinaison de ceux-ci, sont présents à raison de 10 ppm à 1 000 ppm.

5. Composition selon la revendication 1, dans laquelle le ou les éléments zinc, nickel, germanium, ou une combinaison de ceux-ci, sont présents à raison d'environ 500 ppm.

6. Composition selon la revendication 1, dans laquelle la brasure possède une conductibilité thermique inférieure à 9 W/mK.

7. Composition selon la revendication 1, dans laquelle la brasure possède une force de mouillage sur Ag, Ni, Au ou Cu mouillé d'environ 0,2 micro-N/mm sur une balance de mouillage après 1 seconde.

8. Composition selon la revendication 1, dans laquelle l'élément chimique est le phosphore.

9. Composition selon la revendication 1, dans laquelle l'alliage est mis sous forme au moins de fil, de ruban, de préforme, d'anode, de sphère, de pâte ou de lingot d'évaporation.

10. Composition selon la revendication 1, qui comprend du germanium.

11. Composition selon la revendication 10, qui comprend du germanium à une concentration comprise entre environ 10 ppm et environ 1 000 ppm.

12. Dispositif électronique comprenant une puce semiconducteur couplée à une surface via un matériau comprenant la composition selon la revendication 1.

13. Dispositif électronique selon la revendication 12, dans lequel au moins une partie de la puce semiconducteur est métallisée avec Ag.

14. Dispositif électronique selon la revendication 12, dans lequel au moins une partie de la surface est métallisée avec Ag, Cu, Ni ou Au.

15. Dispositif électronique selon la revendication 12, dans lequel la surface comprend une grille de connexion métallisée à l'argent ou métallisée au nickel.

16. Procédé de fabrication d'une composition de brasure, comprenant les étapes consistant à:
se procurer les constituants de l'alliage défini dans la revendication 1, dans les quantités définies dans la revendication 1 ; et
faire fondre les constituants à une température d'au moins 960°C pour former une composition de brasure possédant un solidus non inférieur à 262,5°C et un liquidus non supérieur à 400°C.

17. Procédé selon la revendication 16, dans lequel l'Ag est présent à raison de 7 % en poids à 18 % en poids et Bi à raison de 98 % en poids à 82 % en poids.

18. Procédé selon la revendication 16, dans lequel le ou les éléments zinc, nickel, germanium, ou une combinaison de ceux-ci, sont présents à raison d'environ 500 ppm.

19. Utilisation comme brasure d'une composition telle que définie dans l'une quelconque des revendications 1 à 11.
